# DEMANDE DE BREVET EUROPEEN

(11) **EP 4 730 049 A1**
(43) Date de publication de la demande: **22.04.2026**
(21) Numéro de dépôt: 24207484.7
(22) Date de dépôt: 18.10.2024
(51) Int. Cl.: G04B 15/14, G04B 17/06, G04B 17/22, G04D 3/00, G04B 13/02

(54) **PROCÉDÉ DE FABRICATION DE COMPOSANTS HORLOGERS EN SILICIUM**

(71) Demandeur: Richemont International S.A., 1752 Villars-sur-Glâne (CH)
(72) Inventeur: CHABART, Mickaël, 2014 Fleurier (CH); DEMOLON, Pierre, 2023 Gorgier (CH)
(74) Mandataire: Novagraaf International SA

(57) **Abrégé**

Un procédé de fabrication de composants horlogers (90) dans une plaquette de type SOI comprend les étapes de : (a) former une couche en oxyde de silicium structurée (50) sur la surface supérieure de la couche de travail (30) de la plaquette, son épaisseur (eso) étant plus importante que l'épaisseur (e₄₀) de la couche d'oxyde enterrée (40) de la plaquette; (b) former les composants (90) en gravant, au travers de cette couche structurée (50), des motifs dans la couche de travail (30) pour obtenir des régions éliminées (35) qui exposent la couche d'oxyde enterrée (40) en-dessous ; (c) former une couche de protection (55) au moins sur les surfaces des flancs (95) des composants gravés à l'étape (b) ; (d) effectuer une gravure de la couche d'oxyde enterrée (40) et de la couche structurée (50) jusqu'au point auquel des régions (45) de la couche d'oxyde enterrée (40) sont éliminées afin d'obtenir une couche d'oxyde enterrée ajourée (40'), (e) effectuer une gravure du silicium dans la couche de support (20) à travers les régions éliminées (45) de la couche d'oxyde enterrée ajourée (40'), afin d'obtenir une couche de support excavée (20') ayant au moins une cavité (24) formée en dessous d'au moins un des composants horlogers (90) ; et (f) éliminer les parties de la couche d'oxyde enterrée (40) restant entre l'au moins une cavité (24) et l'au moins un composant (90) agencé au-dessus de la cavité (24).

## Description

### Domaine technique

L'invention concerne un procédé de fabrication de composants horlogers en silicium sur une plaquette de type « silicon-on-insulator » (SOI). Un tel procédé de fabrication comprend généralement des étapes de microfabrication incluant la lithographie et la gravure des couches de la plaquette ainsi que des étapes de fabrication postérieures à la gravure incluant la libération des composants.

### Etat de la technique

La fabrication de composants horlogers en silicium tels que, mais de façon non limitative, des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage par gravure dans une plaquette en silicium. Les procédés de réalisation de ces composants horlogers utilisent généralement des plaquettes de silicium monocristallin, mais des plaquettes en silicium polycristallin ou amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde SiO₂ sur le composant. Quand les composants horlogers sont réalisés à partir d'une plaquette en silicium monocristallin, l'une quelconque des trois orientations cristallines <100>, <110> ou <111> peut être utilisée.

Les plaquettes de silicium sont proposées sous forme de galette simple, par exemple des wafers de type SSP (« Single Side polished » en anglais) ou de type DSP (« Dual Side Polished » en anglais). Le document EP3495894 décrit un procédé de fabrication de composants horlogers en silicium utilisant une telle plaquette comprenant une couche simple en silicium sans couche de support. Selon ce document, la plaquette simple a une épaisseur sensiblement égale à l'épaisseur maximale des composants horlogers à fabriquer, et pour former les composants horlogers, on effectue une étape de gravure dans toute l'épaisseur de la plaquette, la totalité du matériau du composant présent dans la plaquette étant ainsi utilisée pour former les composants horlogers, sans fonction de support dans la plaquette. Après leur formation, les composants horlogers ne sont supportés structurellement que par des ponts de liaison fins qui les maintiennent attachés aux parties subsistantes de la couche simple en silicium, et il est possible d'effectuer des étapes de fabrication subséquentes sur la quasi-totalité de la surface externe des composants sans qu'il soit nécessaire d'effectuer une étape de libération des composants auparavant. Cependant, dans le procédé de fabrication du document EP3495894, l'étape de gravure est délicate car elle a lieu dans une plaquette relativement mince, et donc fragile, sans aucun support.

Alternativement, les plaquettes SOI (« silicon-on-insulator » en anglais) sont souvent utilisées pour la fabrication de composants horlogers. Une plaquette SOI comprend une couche de travail en silicium (la couche « device » en anglais) dans laquelle les composants horlogers sont fabriqués, une couche de support en silicium qui sert de substrat ou de support lors de la fabrication des composants (la couche « handle » en anglais), et une couche d'oxyde enterrée en SiO₂ qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail d'une plaquette SOI, les composants sont normalement libérés de la couche de support et de la couche d'oxyde enterrée de la plaquette SOI afin de faciliter des étapes de fabrication subséquentes. De cette manière, après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur quasiment l'ensemble de la surface externe des composants de la plaquette. Les étapes subséquentes peuvent notamment comprendre des étapes d'oxydation et désoxydation pour le lissage des surfaces des composants. Les étapes subséquentes peuvent également comprendre des étapes d'oxydation et désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique. Après ces étapes subséquentes, les composants horlogers peuvent être détachés de la plaquette et montés dans par exemple le mouvement d'une pièce d'horlogerie.

La libération des composants horlogers sur une plaquette SOI peut être réalisée par différentes méthodes. Une approche de libération est décrite dans les documents de brevet JP2017219520 et WO2019180177. Selon cette approche, après la formation des composants par gravure, on fait croître une couche d'oxyde de silicium en surface du silicium. Cette couche d'oxyde sert de protection pour les composants formés. Par la suite, on réalise une photolithographie et une gravure pour exposer le silicium de la couche de support et graver la couche de support en l'attaquant par la face opposée aux composants, ce qui enlève la couche de support en dessous des composants. Pour terminer la libération selon cette alternative, on élimine la couche enterrée du wafer SOI en dessous des composants ainsi que la couche de protection sur les composants. Cette approche de libération est relativement longue et coûteuse, car elle exige une structuration (voire des étapes de photolithographie et de gravure) au travers de la couche de support épaisse de la plaquette SOI.

Selon une autre approche décrite dans le document WO2019180596, après la formation des composants, la couche de travail (ou une partie de cette couche comprenant les composants) est séparée de la couche de support. Cette séparation peut être facilitée par la gravure d'une saignée entourant les composants ainsi que des ouvertures dans la couche de travail. Par la suite, la couche d'oxyde enterrée est gravée avec de la vapeur d'acide hydrofluorique (HF) qui passe au travers des ouvertures dans la couche de travail, et la partie de la couche de travail définie par la saignée est séparée de la couche de support de la plaquette SOI. Dans cette approche de libération, puisque la couche de travail est beaucoup plus fine et fragile que la couche de support, la réalisation d'étapes de fabrication subséquentes est plus délicate et risquée car elles sont effectuées sans le bénéfice de la couche de support, même pour le cas où elle est partiellement éliminée.

Il serait alors avantageux d'avoir un procédé de fabrication de composants horlogers en silicium comprenant des étapes de libération des composants qui sont moins longues, plus efficaces et qui permettent de garder le bénéfice d'un support structurel pour des étapes de fabrication subséquentes qui ont lieu sur les composants après leur libération. Par ailleurs, de manière générale, la fabrication de composants horlogers en silicium comprend un nombre important d'étapes, et il serait alors également désirable d'avoir un procédé de fabrication de tels composants ayant un nombre d'étapes réduit.

### Bref résumé de l'invention

Un but de la présente invention est de proposer un procédé de fabrication d'une pluralité de composants horlogers sur une plaquette SOI, qui permet d'éviter ou de pallier les inconvénients ci-dessus, ou en tout cas d'offrir un meilleur compromis entre ces inconvénients.

En particulier, ce but est au moins partiellement atteint en proposant un nouveau procédé de fabrication de composants horlogers en silicium selon lequel les composants sont libérés sans une gravure longue et couteuse d'une couche de support et selon lequel on peut garder le bénéfice d'un support structurel pour des étapes de fabrication subséquentes effectuées sur les composants après leur libération.

Ainsi, selon un aspect, la présente invention concerne un procédé de fabrication, dans une plaquette de type SOI, d'une pluralité de composants horlogers présentant des flancs ayant des surfaces, la plaquette SOI comprenant une couche de support en silicium, une couche de travail en silicium, et une couche d'oxyde enterrée en oxyde de silicium ayant une épaisseur et séparant la couche de support de la couche de travail. Le procédé comprend les étapes suivantes : (a) former une couche en oxyde de silicium structurée sur la surface supérieure de la couche de travail, ladite couche ayant une épaisseur plus importante que l'épaisseur de la couche d'oxyde enterrée; (b) former les composants horlogers (avec leurs flancs), ou du moins une ébauche des composants horlogers, en gravant, au travers de la couche en oxyde de silicium structurée, des motifs dans la couche de travail afin d'obtenir une couche de travail structurée, la couche de travail structurée comprenant des régions éliminées autour des motifs gravés dans lesquelles le matériau de la couche de travail a été éliminé pour exposer la couche d'oxyde enterrée en-dessous ; (c) former une couche de protection au moins sur les surfaces des flancs des composants horlogers gravés à l'étape (b) ; (d) soit après soit avant l'étape (c), effectuer une gravure de la couche d'oxyde enterrée et de la couche en oxyde de silicium structurée sur la surface supérieure de la couche de travail structurée jusqu'au point auquel des régions de la couche d'oxyde enterrée se trouvant en dessous des régions éliminées de la couche de travail sont éliminées afin d'obtenir une couche d'oxyde enterrée ajourée, une couche en oxyde de silicium structurée amincie étant toujours présente sur la surface supérieure de la couche de travail structurée après cette étape ; (e) effectuer une gravure du silicium dans la couche de support depuis ou à travers les régions éliminées de la couche d'oxyde enterrée ajourée, afin d'obtenir une couche de support excavée ayant au moins une cavité formée en dessous d'au moins un des composants horlogers et/ou en dessous de la couche enterrée en regard dudit au moins un des composants horlogers; et (f) éliminer les parties de la couche d'oxyde enterrée restant entre ladite au moins une cavité et ledit au moins un composant horloger agencé au-dessus de ladite cavité, afin d'obtenir une couche d'oxyde enterrée structurée ayant des parties subsistantes liant toujours la couche de support excavée à la couche de travail structurée.

D'autres caractéristiques avantageuses et privilégiées du procédé de fabrication sont précisées dans la description et les sous-revendications ci-dessous.

### Brève description des figures

Des exemples de mise en oeuvre de l'invention sont indiqués dans la description illustrée par les figures annexées dans lesquelles :
- Les figures 1a-1m illustrent schématiquement une série d'étapes de fabrication d'un composant horloger en silicium dans une plaquette SOI selon un mode de réalisation ;
- Les figures 2 et 2A sont des vues de dessus de la couche de travail d'une plaquette SOI après les étapes de la figure 1 selon un mode de réalisation ; et
- La figure 3 est une vue en section selon la ligne III-III de la figure 2.

### Exemples de mode de réalisation de l'invention

Dans tout ce qui suit, les orientations sont les orientations des figures. En particulier, les termes comme « supérieur », « inférieur », « gauche », « droit », « dessus », « dessous », « horizontal », « vertical », « vers l'avant » et « vers l'arrière » s'entendent généralement par rapport au sens de représentation des figures. Les figures sont schématiques et peuvent présenter des proportions et/ou des aspects différents de la réalité même au sein d'une même figure, mais illustrent à tout le moins le déroulement et/ou les étapes des procédés décrits.

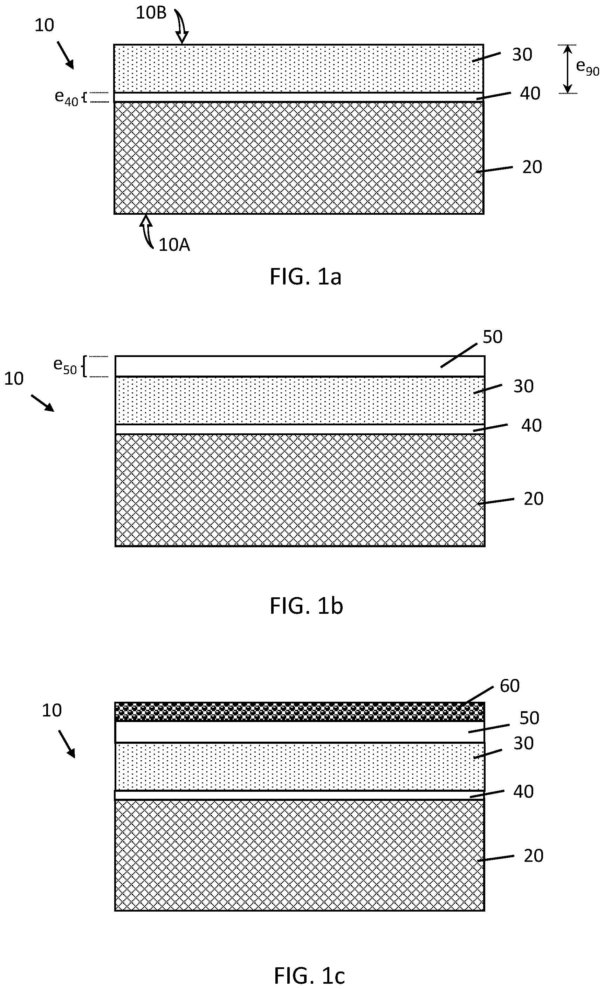

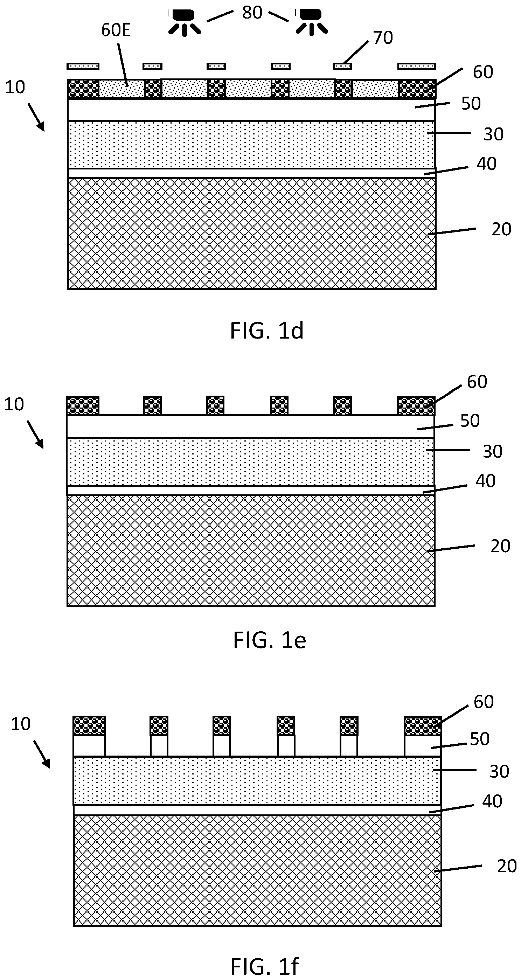

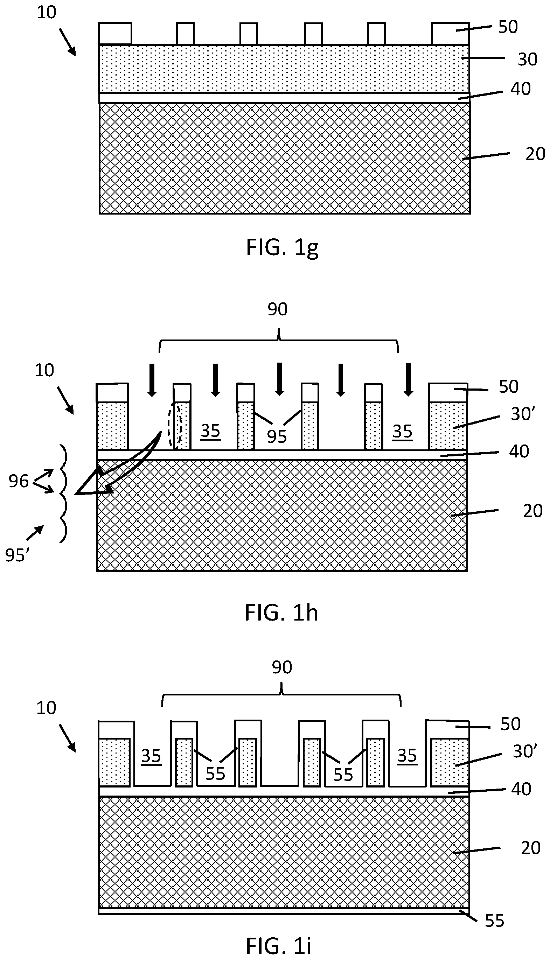

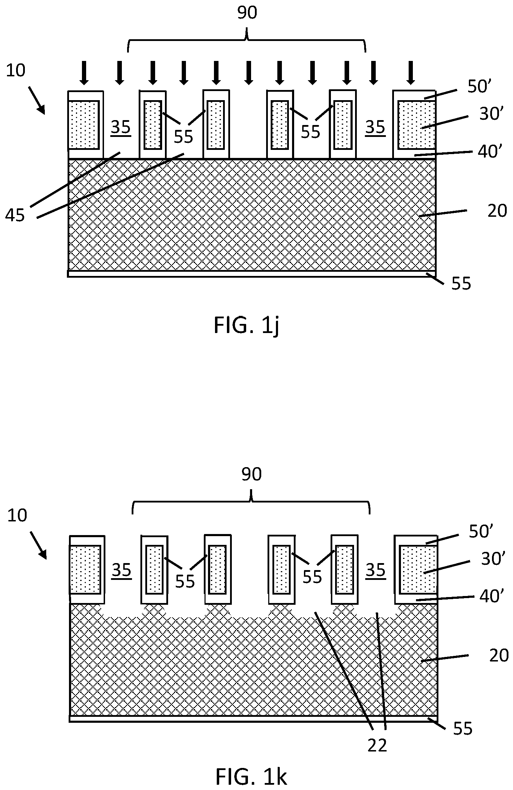

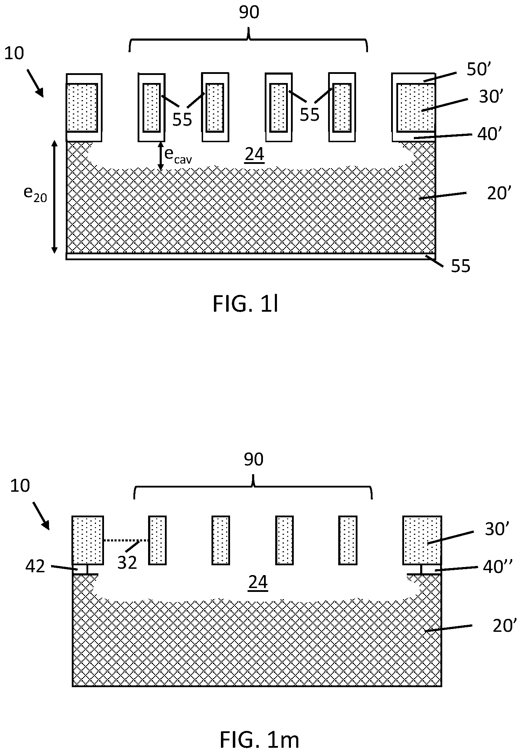

Les figures 1a-1m illustrent une série d'étapes de fabrication schématiques d'un composant horloger dans une plaquette SOI 10 selon un mode de réalisation de l'invention. Bien entendu, plusieurs composants horlogers peuvent être fabriqués dans la plaquette SOI 10 en même temps, mais les vues de la figure 1 sont isolées sur un seul composant par simplicité. Le procédé commence avec une plaquette SOI 10 illustrée à la figure 1a, cette plaquette SOI 10 comprenant une couche de support 20 en silicium, une couche de travail 30 en silicium, et une couche d'oxyde enterrée 40 séparant les deux couches de silicium 20, 30 qui est notamment en oxyde de silicium (SiO₂). Le dessin n'est pas à l'échelle, mais à titre d'exemple, la couche de support 20 peut avoir une épaisseur jusqu'à 500 µm, la couche de travail 30 peut avoir une épaisseur de 120 µm, et la couche d'oxyde enterrée 40 peut avoir une épaisseur e₄₀ de 0.5-2 µm. Les couches de support et de travail peuvent être du même type de silicium ou de types différents - par exemple de silicium monocristallin avec une orientation cristalline quelconque, du silicium polycristallin, ou du silicium amorphe. Les couches de silicium 20, 30 (et notamment la couche de travail 30) peuvent être dopés type N ou type P. Par exemple, l'utilisation d'un silicium fortement dopé peut être avantageuse pour la fabrication des résonateurs car, par exemple, on constate une déformation moindre de la matière dopée lors de l'oxydation thermique sous certaines conditions.

L'épaisseur de la couche de travail 30 correspond généralement à l'épaisseur maximale e₉₀ des composants horlogers. La plaquette SOI 10 comprend un côté inférieur 10A (voire le côté couche de support 20), et c'est depuis ce côté que la plaquette 10 repose normalement sur des équipements lors des différents étapes de microfabrication. La plaquette 10 comprend également un côté supérieur 10B (voire le côté couche de travail 30), et c'est depuis ce côté que les étapes de microfabrication pour former les composants horlogers sont généralement effectuées.

Dans la figure 1b, une étape de lithographie commence avec la formation d'une couche d'oxyde de silicium 50 sur la surface supérieure de la couche de travail 30. Par « lithographie », on entend l'ensemble des opérations permettant de transférer une image ou un motif sur ou au-dessus de la plaquette SOI 10 vers cette dernière. La couche d'oxyde 50 a une épaisseur e₅₀ plus importante que l'épaisseur e₄₀ de la couche d'oxyde enterrée 40, par exemple une épaisseur de 1-6 µm. La couche d'oxyde 50 peut être formée par oxydation thermique ou alternativement par un dépôt de type PVD, CVD, ou ALD. Si la couche d'oxyde 50 est formée par un procédé de dépôt directionnel tel que le CVD ou le PVD, l'oxyde se forme uniquement sur la surface supérieure de la couche de support 20, tel qu'illustré à la figure 1b. Alternativement, si la couche d'oxyde 50 est formée par oxydation thermique, on remarque que l'oxyde 50 peut se former généralement en même temps sur la surface de la couche de support 20 (si cette dernière n'est pas couverte par un masque) ou encore un second dépôt directionnel de type CVD ou PVD peut être effectué sur la surface de la couche de support 20. De manière générale, la formation de la couche d'oxyde 50 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche de travail 30.

A la figure 1c, la couche d'oxyde 50 est recouverte d'une couche de résine 60, qui est typiquement une résine photosensible de type positif ou négatif. Cette couche de résine peut avoir une épaisseur comprise entre 0.5 - 12 µm, à titre purement illustratif. Par la suite, dans la figure 1d, la couche de résine 60 est structurée de préférence en utilisant une étape de photolithographie avec une source de lumière ultraviolette 80 ainsi que, par exemple, un masque d'exposition 70 tel qu'un photomasque. Un système de stepper et réticule peut également être utilisé pour l'étape de photolithographie, ou alors un système d'écriture directe (i.e. sans photomasque) tel qu'un système de lithographie par laser ou par faisceau d'électrons (la lithographie e-beam). Dans l'exemple illustré, la couche 60 comprend une résine photosensible de type positif dont les parties 60E de la résine qui sont exposées à la lumière deviennent solubles dans un révélateur et les parties non exposées restent insolubles.

Dans la figure 1e, la couche de résine 60 est ouverte après avoir été développée par un révélateur, notamment un solvant qui élimine les parties exposées 60E de la résine par voie chimique. Ensuite, à la figure 1f, les parties de la couche d'oxyde 50 qui se trouvaient en dessous des parties exposées 60E de la résine sont aussi retirées de la surface de la couche de travail 30, et la couche d'oxyde 50 est donc structurée sur la surface de la couche de travail. Cette étape peut être réalisée par exemple en employant une gravure plasma sélective directionnelle utilisant un ou plusieurs gaz fluorés (tels que CHF₃, C₄F₈, et/ou SF₆) en combinaison avec au moins un des gaz He et/ou H₂ en fonction des sélectivités et des vitesses de gravure souhaitées. L'utilisation d'une technique de gravure directionnelle est généralement privilégiée lors de cette étape car elle est plus précise, mais alternativement une gravure à base de vapeur d'acide hydrofluorique (HF) ou à base d'une solution liquide tampon de type BHF peut aussi être utilisée.

A l'étape illustrée à la figure 1g, la partie restante de la couche de résine 60 peut être éliminée, par exemple en utilisant un plasma dioxygène (O₂), mais optionnellement on peut garder la partie restante de cette couche comme masque en plus de la couche d'oxyde 50. Les étapes des figures 1a - 1g servent alors à former une couche en oxyde de silicium structurée 50 sur la surface supérieure de la couche de travail 30, cette couche ayant une épaisseur eso plus importante que l'épaisseur e₄₀ de la couche d'oxyde enterrée 40. Selon des variantes, la couche en oxyde de silicium structurée peut être formée autrement.

Ensuite, à l'étape de la figure 1h, des motifs sont gravés dans la couche de travail 30 au travers de la couche en oxyde de silicium 50 structurée, et optionnellement la couche de résine restante 60, pour former le composant horloger 90 (ou du moins une ébauche du composant). En général, les motifs gravés s'étendent sur toute l'épaisseur de la couche de travail 30 tel qu'illustré, et à cette fin la couche d'oxyde enterrée 40 peut agir comme un stop lors de la gravure. De cette manière, l'épaisseur des composants horlogers 90 correspond à l'épaisseur de la couche de travail 30. Comme illustré, à la fin de cette étape on obtient une couche de travail structurée 30' avec des régions 35 se trouvant autour de la structure du composant dans lesquelles le matériau de la couche de travail 30 a été éliminé, exposant ainsi des parties de la couche d'oxyde enterrée 40 en dessous de ces régions éliminées 35.

La gravure à l'étape de la figure 1h peut notamment être effectuée par une technique de gravure ionique réactive profonde (également connue sous l'acronyme DRIE pour « Deep Reactive Ion Etching » en anglais), par exemple en utilisant le SF₆ comme gaz réactif pour graver le silicium de la couche device et en utilisant le gaz C₄F₈ périodiquement comme gaz de passivation pour la protection des surfaces des flancs latéraux 95 du composant horloger. La gravure DRIE permet de former des trous et des tranchées profondes dans la couche 30 avec un rapport largeur/hauteur important, ce qui est bien adapté pour des composants micromécaniques comme des composants horlogers. De manière connue, l'utilisation du gaz C₄F₈ comme gaz de passivation produit une couche de fluoropolymère sur les surfaces des flancs latéraux 95. Une telle couche, qui a typiquement une épaisseur de 0.1-5 µm, peut être enlevée des flancs par une technique appropriée par exemple en utilisant un plasma dioxygène (O₂). Alternativement, la structuration de la couche de travail peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Cependant, la résolution dimensionnelle des structures gravées est généralement moins bonne avec une structuration par gravure humide/chimique qu'avec une gravure ionique réactive profonde.

Comme indiqué ci-dessus, il est également possible pour la partie restante de la couche de résine 60 d'être toujours présente lors de l'étape de gravure profonde (DRIE ou autre) de la couche de travail 30. Cette partie restante de la couche de résine peut être retirée après la gravure, et dans ce cas la couche de travail 30 est gravée au travers des deux couches 50, 60 structurées. A titre d'exemple, une résine positive peut être retirée par des solvants de type acétone ou diméthylsulfoxyde (DMSO) ou avec un plasma O₂ soit avant soit après l'étape de gravure. Pour une résine négative comme le SU-8, un plasma CF₄/O₂ peut être employé pour son retrait.

Les figures 1i-1m illustrent l'approche de libération des composants horlogers 90 selon ce mode de réalisation de l'invention. A la figure 1i, une couche d'oxyde 55 de silicium (SiO₂) est de préférence formée sur l'ensemble des surfaces exposées de la plaquette 10, incluant les surfaces des flancs 95 du composant horloger. De préférence, cette couche d'oxyde 55 est formée par oxydation thermique et donc se forme également sur tout le silicium exposé de la plaquette SOI 10 incluant la surface inferieure de la couche de support 20, comme illustré. La couche d'oxyde 55 rejoint les couches d'oxydes 50 et 40 déjà présentes sur les surfaces supérieure et inférieure (en dessous) du composant horloger 90, et ces dernières couches peuvent devenir légèrement plus épaisses durant l'oxydation thermique, du moins où la couche d'oxyde enterrée 40 est exposée en dessous des régions 35. L'épaisseur de la couche d'oxyde 55 peut varier mais de préférence elle est comprise entre 0.05 et 2um.

La formation de la couche d'oxyde 55 sert notamment à protéger les surfaces des flancs 95 des composants horlogers 90 ainsi que d'autres endroits de la plaquette où le silicium est exposé lors des étapes de fabrication suivantes du procédé. Alternativement, une couche de protection en oxyde de silicium (SiOz) ou en un autre matériau (par exemple une résine, un polymère, ou un autre oxyde comme l'Al₂O₃) peut être sélectivement formée sur ces surfaces et notamment sur les surfaces des flancs 95. Un tel dépôt sélectif peut être réalisé à titre d'exemple par une technique à base de l'ALD (en anglais « atomic layer deposition ») tel que décrit dans le document Taguhi Yeghoyan, Vincent Pesce, Moustapha Jaffal, Gauthier Lefevre, Rémy Gassilloud, Nicolas Posseme, Marceline Bonvalot, Christophe Vallée; Low température Topographically Selective Déposition by Plasma Enhanced Atomic Layer Deposition with ion bombardment assistance. J. Vac. Sci. Technol. A 1 May 2021; 39 (3): 032416 ou le document A. Chaker, C. Vallee, V. Pesce, S. Belahcen, R. Vallat, R. Gassilloud, N. Posseme, M. Bonvalot, A. Bsiesy; Topographically selective déposition. Appl. Phys. Lett. 28 January 2019; 114 (4): 043101. D'autres techniques de dépôt sélectifs pourraient également être employées. Le dépôt sélectif d'une couche de protection peut aussi être effectué ultérieurement, après une étape de gravure directionnelle décrite ci-dessous en association avec la figure 1j. Cependant, un dépôt sélectif est généralement plus compliqué à réaliser sur les surfaces verticales des flancs 95 des composants horlogers, et pour cette raison la formation de la couche d'oxyde 55 par oxydation thermique reste privilégiée.

Comme décrit ci-dessus, si une gravure DRIE utilisant un gaz fluoré tel que le C₄F₈ a été employée à l'étape de la figure 1h, une couche de fluoropolymère se forme généralement sur les surfaces des flancs latéraux 95. Selon une variante, on peut garder et ne pas enlever cette couche fluoropolymère après la gravure DRIE de cette étape de la figure 1h, et cette couche fluoropolymère peut par la suite servir comme une couche de protection de ces flancs pour les étapes qui suivent. Une telle couche de protection peut avantageusement être utilisée, par exemple, quand une gravure ultérieure de la couche de support 20 (telle que décrite ci-dessous en lien avec les figures 1k et 1l) est réalisée par une gravure en phase vapeur à base de difluorure de xénon (XeF₂), car une couche fluoropolymère est typiquement hautement sélective par rapport à cet agent de gravure.

Ensuite, à la figure 1j, une gravure qui est de préférence directionnelle, notamment de type DRIE ou ICP-RIE (« Inductively Coupled Plasma - Reactive Ion Etching » en anglais), est effectuée pour graver les couches d'oxyde 40 et 50 de la plaquette jusqu'au point auquel les régions 45 de la couche d'oxyde enterrée 40 se trouvant en dessous des régions 35 sont éliminées. Cette gravure directionnelle a lieu dans le sens vertical de la plaquette 10 depuis son côté 10b comme illustré par les flèches dans la figure 1j et agit sur toutes les surfaces perpendiculaires au flux de gravure. Puisque l'épaisseur de la couche d'oxyde 50 est plus importante que l'épaisseur de la couche d'oxyde enterrée 40, en contrôlant les paramètres et la durée de la gravure, une couche d'oxyde amincie 50' (avec une plus faible épaisseur que la couche 50 initiale) est toujours présente sur la surface supérieure de la couche de travail structurée 30' à la fin de cette étape de gravure. La gravure étant directionnelle, les couches d'oxyde 55 sur les surfaces verticales de la couche de travail structurée 30', et notamment sur les surfaces des flancs 95 des composants horlogers, sont peu exposées aux ions réactifs durant la gravure et donc sont peu, voire pas, gravées, la gravure directionnelle agissant surtout sur les couches d'oxydes 40, 50 qui sont disposées horizontalement sur la plaquette 10. Pour cette raison, la présence d'une couche de protection sur les surfaces des flancs 95 n'est pas indispensable durant la gravure directionnelle, même si cela est privilégié.

Une gravure plasma sélective directionnelle utilisant au moins un gaz fluoré (tel que CHF₃, C₄F₈, et/ou SF₆) en combinaison avec au moins un des gaz He et/ou H₂ peut être employée lors de l'étape de la figure 1j en fonction des sélectivités et des vitesses de gravure voulues. Avantageusement, cette étape de gravure directionnelle peut être réalisée sans masque d'exposition rendant cette étape relativement rapide et économique. A la fin de cette étape, on obtient une couche d'oxyde enterrée ajourée 40' avec des régions 45 (se trouvant en dessous des régions 35) dans lesquelles l'oxyde de la couche enterrée a été éliminé exposant la surface supérieure de la couche de support 20.

Selon une variante, si la couche de protection sur les surfaces des flancs 95 comprend un matériau autre que l'oxyde de silicium (SiOz), la gravure effectuée lors de l'étape de la figure 1j n'a pas forcement besoin d'être directionnelle, et une gravure à base de vapeur d'acide hydrofluorique (HF) ou à base d'une solution liquide tampon de type BHF peut être utilisée à la place, afin d'ouvrir uniquement la couche SiO2 de protection 40 sans ouvrir la couche de protection 50.

Si une couche de protection n'a pas été formée sur les surfaces des flancs 95 des composants horlogers 90 avant la gravure directionnelle des couches d'oxyde 40, 50, une telle couche de protection peut être déposée sélectivement sur ces flancs après cette gravure directionnelle des couches d'oxyde 40, 50. Dans ce cas, il est important que le dépôt sélectif ne couvre les régions exposées de la couche de support 20 en dessous des régions éliminées 45 de la couche d'oxyde enterrée.

A la figure 1k, on commence une étape de gravure du silicium de la couche de support 20 afin d'excaver une portion de la couche de support 20 en dessous des composants horlogers 90. Plus particulièrement, la couche de support 20 est gravée où elle est exposée en dessous des régions éliminées 45 de la couche d'oxyde enterrée. Selon la variante illustrée, une gravure humide/chimique anisotrope est utilisée à cette étape pour former des régions gravées 22 dans la couche de support 20. La gravure anisotrope permet d'éliminer le silicium plus rapidement dans certaines directions dans chaque région gravée 22, selon les orientations cristallines de la plaquette. Les surfaces des flancs dans les régions gravées 22 forment donc un angle et en général cet angle varie en fonction de différents paramètres incluant notamment l'orientation cristalline du silicium. De préférence, un bain d'hydroxyde de potassium (KOH) peut être utilisé pour cette gravure anisotrope, mais alternativement on peut également utiliser par exemple un bain de d'hydroxyde de tétraméthylammonium (TMAH). Selon une autre variante pour l'étape de la figure 1k, on peut utiliser une technique de gravure isotrope pour attaquer le silicium de la couche de support 20, par exemple une gravure en phase vapeur à base de difluorure de xénon (XeF₂). Une telle gravure isotrope élimine le silicium plus ou moins uniformément dans toutes les directions créant ainsi des régions gravées 22 de la couche de support ayant la forme (en section) de demi-cercles en dessous des régions éliminées de la couche d'oxyde enterrée.

De préférence, l'étape de gravure de la figure 1k continue afin que les régions gravées 22 dans lesquelles le silicium de la couche de support a été éliminé s'unissent pour former une cavité 24 s'étendant en dessous de chaque composant horloger 90, comme illustré dans la figure 1l. On obtient donc une couche de support excavée 20' comprenant ces cavités 24 sur sa surface supérieure. Si la gravure (anisotrope ou isotrope) de la couche de support n'est pas strictement contrôlée, les cavités 24 n'ont typiquement pas une épaisseur uniforme, mais de préférence l'épaisseur maximale de chaque cavité e_{cav} est au plus égale à 50% de l'épaisseur e₂₀ de la couche de support, et il est encore plus préféré que l'épaisseur maximale de chaque cavité e_{cav} est au plus égale à 25% de l'épaisseur e₂₀ de la couche de support. Cependant, l'épaisseur maximale de chaque cavité e_{cav} peut également être plus importante, et il est même possible que la cavité 24 traverse toute l'épaisseur de la couche de support 20 (voire e_{cav} est égale à e₂₀).

Selon le mode de réalisation privilégié dans lequel la réalisation de la couche d'oxyde 55 durant l'étape de la figure 1i est par une oxydation thermique, la gravure du silicium aux étapes des figures 1k et 1l attaque la couche de support 20 uniquement au travers des régions éliminées de la couche d'oxyde enterrée ajourée 40', les autres surfaces de cette couche étant protégées par la couche d'oxyde 55, particulièrement la couche d'oxyde en face arrière (voire du côté 10A de la plaquette).

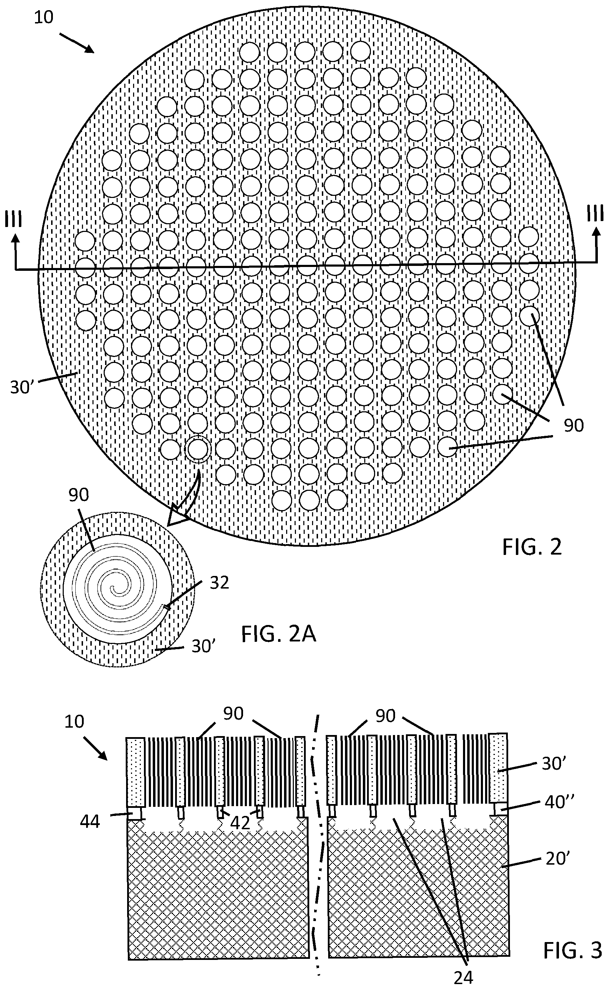

Finalement, pour compléter la libération des composants horlogers, on effectue à la figure 1m une étape de désoxydation, ce qui élimine les couches d'oxyde 50' et 55 ainsi que les parties de la couche d'oxyde enterrée ajourée 40' restant entre chaque cavité 24 et le ou les composants horlogers 90 au-dessus de cette cavité. Cette étape de désoxydation peut être réalisée, par exemple, par une gravure par voie humide ou en phase vapeur ou gaz, par exemple à base d'acide fluorhydrique (HF) ou de gaz HF anhydre. On obtient donc une couche d'oxyde enterrée structurée 40" dont une partie importante de la couche a été éliminée, mais qui comprend des parties 42, 44 (voir la figure 3) toujours présentes en dehors des zones des composants horlogers 90. Ces parties subsistantes 42, 44 de la couche d'oxyde enterrée structurée 40" gardent la liaison entre la couche de travail structurée 30' et la couche de support excavée 20'.

Si la couche de protection sur les surfaces des flancs 95 comprend un matériau autre que l'oxyde de silicium (SiO₂), cette couche de protection pourrait être enlevée ou éliminée avant ou après l'étape de la figure 1m par une technique appropriée. Par exemple, dans le cadre d'une résine ou d'une couche de fluoropolymère, on peut utiliser un plasma dioxygène (O₂) pour enlever une telle couche de protection.

Les composants horlogers 90 sont alors libérés sur la plaquette SOI permettant la réalisation des étapes de fabrication subséquentes, comme le sera décrit ci-dessous, sur la quasi-totalité de la surface externe de ces composants. A cette fin, après la libération, les composants horlogers 90 ne sont supportés structurellement que par des ponts de liaison (illustrés schématiquement par le trait 32 dans la figure 1m; en réalité le pont s'étend sur toute l'épaisseur du composant) dans la couche de travail structurée 30'. De cette manière, les composants 90 restent attachés aux parties subsistantes de la couche de travail structurée 30'. Cela est illustré dans la figure 2 qui est une vue de dessus de la plaquette SOI 10 et notamment de la couche de travail structurée 30' après les étapes de fabrication des figures 1a-1m selon un mode de réalisation. A noter que dans la figure 2 les composants horlogers 90 se trouvent dans des zones de la couche qui sont simplement illustrés par des cercles vides afin de ne pas surcharger le dessin, mais la figure 2A donne une vue magnifiée d'une de ces zones montrant à titre d'exemple un spiral comme le composant horloger et son pont de liaison 32. La figure 3 est également une vue en section selon la ligne III-III de la figure 2 montrant une cavité 24 libérant chacun des composants horlogers 90 par le dessous. Malgré cette libération, la couche de travail structurée 30' est toujours soutenue par la couche de support excavée 20' de la plaquette SOI, ces deux couches étant liées ensemble par le biais des parties subsistantes 42, 44 de la couche d'oxyde enterrée structurée 40". Comme illustré aux figures 2 et 3, les parties subsistantes 44 situées à la périphérie de la plaquette 10 ont de préférence une largeur plus importante que les parties subsistantes 42 se trouvant entre les composants horlogers 90.

Dans le mode de réalisation ci-dessus, chaque composant horloger 90 de la plaquette a sa propre cavité 24, voire une cavité 24 dédiée à ce composant qui s'étend uniquement en dessous de ce composant. Selon un autre mode de réalisation, une seule cavité 24 peut s'étendre en dessous de plusieurs composants de la plaquette, la couche d'oxyde enterrée structurée 40" n'ayant pas des parties subsistantes 42 entre des composants situés au-dessus d'une même cavité. On peut même avoir une seule cavité 24 qui s'étend en dessous de tous les composants de la plaquette, et dans ce cas c'est uniquement des parties subsistantes périphériques 44 de la couche d'oxyde enterrée structurée 40" qui maintiennent la liaison entre la couche de travail structurée 30' et la couche de support excavée 20'.

Après l'étape de gravure de la couche de travail pour former les composants horlogers 90 (cf. la figure 1h), il est connu que les surfaces des flancs 95 des motifs structurés des composants 90 possèdent une rugosité relativement importante. Dans le cadre d'une gravure de type DRIE, cette rugosité se manifeste en forme d'une surface 95' avec des ondulations souvent appelées « scallops » avec des pics 96 comme illustré à la partie gauche de la figure 1h. En fait, lors d'une gravure DRIE on alterne entre une phase de gravure du silicium et une phase de passivation ce qui résulte en la surface ondulée 95'. Après une gravure DRIE ou un autre type de gravure, la rugosité des surfaces des flancs 95 peut être réduite par une étape de lissage, ce qui renforce ces surfaces mécaniquement en limitant les amorces de rupture. Ce lissage peut notamment être effectué par une étape d'oxydation thermique suivie par une étape de désoxydation, constituée par exemple d'une gravure par voie humide ou en phase vapeur, par exemple à base d'acide fluorhydrique (HF) ou de gaz HF anhydre. De manière connue, lors de l'oxydation thermique, le silicium à la surface des flancs 95 est consommée, et cette consommation est généralement plus rapide vers les pics 96, ce qui résulte en une surface de silicium plus lisse après la désoxydation.

Comme mentionné ci-dessus, de préférence à l'étape de la figure 1i on forme la couche d'oxyde 55 sur les surfaces des flancs 95 du composant 90 par oxydation thermique. Cela permet, contrairement aux procédés de fabrication de l'art antérieur où le lissage est effectué après la libération des composants horlogers 90, de réaliser un lissage des flancs des composants horlogers durant la libération. Plus précisément, lors de l'étape de désoxydation à la figure 1m, on réalise non seulement la libération des composants horlogers 90 dans la plaquette SOI mais en même temps un lissage des surfaces des flancs 95 de ces composants sur la plaquette 10. En réalisant le lissage et la libération avec une seule étape de désoxydation selon ce mode de réalisation de la présente invention, le nombre d'étapes dans le procédé de fabrication des composants horlogers 90 dans la plaquette SOI est favorablement réduit.

Après la libération des composants horlogers 90 tel que décrit ci-dessus, une autre étape d'oxydation thermique suivie par une étape de désoxydation peut être réalisée pour effectuer un lissage au moins une nouvelle fois, si souhaité. D'autres étapes de fabrication subséquentes au lissage et à la libération peuvent aussi être effectuées. Par exemple, on peut effectuer une autre étape d'oxydation suivie par une désoxydation pour ajuster les dimensions des composants, ou on peut former une couche d'oxyde de silicium (SiO₂) permanente sur au moins une partie de la surface externe des composants horlogers 90. Dans le cadre d'un spiral ou d'un autre type de résonateur horloger, une telle couche d'oxyde permanente compense les variations du module d'Young de l'âme du spiral en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachées à la plaquette 10, comme par exemple pour assembler le composant à un axe, un tigeron, un piton ou une virole.

Les différentes étapes d'oxydation mentionnées ci-dessus peuvent être réalisées en plaçant la plaquette 10 dans un four à une température comprise entre 800°C et 1200°C et dans une atmosphère oxydante comprenant par exemple la vapeur d'eau ou du gaz de dioxygène (O₂). L'épaisseur de la couche d'oxyde formée dépend de manière connue de la durée de l'étape d'oxydation.

Une fois que les étapes de fabrication des composants horlogers 90 sur la plaquette 10 sont complétées, les composants horlogers peuvent être détachées individuellement (notamment en cassant les ponts 32) et par la suite assemblé et monté chacun dans une pièce d'horlogerie, par exemple dans un oscillateur ou dans un mécanisme d'échappement d'un mouvement horloger mécanique.

La présente invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation et leurs variantes, ceci ne signifie pas nécessairement que chaque référence concerne le même mode de réalisation ou variante, ou que les caractéristiques s'appliquent seulement à un seul mode de réalisation ou variante. De simples caractéristiques de différents modes de réalisation et leurs variantes peuvent également être combinées et/ou interchangées pour fournir d'autres réalisations.

## Revendications

1. Procédé de fabrication, dans une plaquette de type SOI (10), d'une pluralité de composants horlogers (90) présentant des flancs (95) ayant des surfaces, la plaquette SOI (10) comprenant une couche de support (20) en silicium, une couche de travail (30) en silicium, et une couche d'oxyde enterrée (40) en oxyde de silicium ayant une épaisseur (e₄₀) et séparant la couche de support (20) de la couche de travail (30), le procédé comprenant les étapes suivantes :
(a) former une couche en oxyde de silicium structurée (50) sur la surface supérieure de la couche de travail (30), ladite couche en oxyde de silicium structurée (50) ayant une épaisseur (eso) plus importante que l'épaisseur (e₄₀) de la couche d'oxyde enterrée (40) ;
(b) former les composants horlogers (90) en gravant, au travers de la couche en oxyde de silicium structurée (50), des motifs dans la couche de travail (30) afin d'obtenir une couche de travail structurée (30'), la couche de travail structurée (30') comprenant des régions éliminées (35) autour des motifs gravés dans lesquelles le matériau de la couche de travail a été éliminé pour exposer la couche d'oxyde enterrée (40) en-dessous ;
(c) former une couche de protection (55) au moins sur les surfaces des flancs (95) des composants horlogers gravés à l'étape (b) ;
(d) soit après soit avant l'étape (c), effectuer une gravure de la couche d'oxyde enterrée (40) et de la couche en oxyde de silicium structurée (50) sur la surface supérieure de la couche de travail structurée (30') jusqu'au point auquel des régions (45) de la couche d'oxyde enterrée (40) se trouvant en dessous des régions éliminées (35) de la couche de travail sont éliminées afin d'obtenir une couche d'oxyde enterrée ajourée (40'), une couche en oxyde de silicium structurée amincie (50') étant toujours présente sur la surface supérieure de la couche de travail structurée (30') après cette étape ;
(e) effectuer une gravure du silicium dans la couche de support (20) à travers les régions éliminées (45) de la couche d'oxyde enterrée ajourée (40'), afin d'obtenir une couche de support excavée (20') ayant au moins une cavité (24) formée en dessous d'au moins un des composants horlogers (90) ; et
(f) éliminer les parties de la couche d'oxyde enterrée (40) restant entre ladite au moins une cavité (24) et ledit au moins un composant horloger (90) agencé au-dessus de ladite cavité (24), afin d'obtenir une couche d'oxyde enterrée structurée (40") ayant des parties subsistantes (42, 44) liant toujours la couche de support excavée (20') à la couche de travail structurée (30').

2. Procédé selon la revendication précédente, dans lequel l'étape (f) comprend également l'élimination de la couche en oxyde de silicium structurée amincie (50') sur la surface supérieure de la couche de travail structurée (30').

3. Procédé selon l'une des revendications précédentes, dans lequel la formation de la couche de protection (55) à l'étape (c) est réalisée avant la gravure directionnelle de l'étape (d).

4. Procédé selon la revendication précédente, dans lequel la formation de la couche de protection (55) à l'étape (c) est réalisée par oxydation thermique, la couche de protection (55) étant en oxyde de silicium et se formant également sur des surfaces en silicium exposées de la couche de support (20).

5. Procédé selon la revendication précédente, dans lequel l'étape (f) comprend également l'élimination de la couche de protection (55) afin de lisser les surfaces des flancs (95) des composants horlogers (90) et de libérer les composants horlogers (90) dans la plaquette SOI (10), les composants horlogers (90) libérés n'étant supportés structurellement que par des ponts de liaison (32) dans la couche de travail structurée (30').

6. Procédé selon l'une des revendications précédentes, dans lequel la gravure de l'étape (d) est une gravure directionnelle de type DRIE ou ICP-RIE.

7. Procédé selon la revendication précédente, dans lequel la gravure directionnelle de l'étape (d) utilise au moins un gaz fluoré tel que CHF₃, C₄F₈, et/ou SF₆ en combinaison avec au moins un des gaz He et/ou H₂.

8. Procédé selon l'une des revendications précédentes, dans lequel la gravure de la couche de support (20) à l'étape (e) comprend une gravure anisotrope.

9. Procédé selon la revendication précédente, dans lequel la gravure à l'étape (e) utilise un bain d'hydroxyde de potassium (KOH) ou un bain de d'hydroxyde de tétraméthylammonium (TMAH).

10. Procédé selon l'une des revendications 1 à 7, dans lequel la gravure de la couche de support (20) à l'étape (e) comprend une gravure isotrope.

11. Procédé selon la revendication précédente, dans lequel la gravure à l'étape (e) est une gravure en phase vapeur à base de difluorure de xénon (XeF₂).

12. Procédé selon l'une des revendications précédentes, dans lequel l'étape (f) est réalisée par une gravure par voie humide ou en phase vapeur à base d'acide fluorhydrique (HF) ou de gaz HF anhydre.

13. Procédé selon l'une des revendications précédentes, dans lequel chaque composant horloger (90) de la plaquette SOI (10) a sa propre cavité (24) qui s'étend uniquement en dessous de ce composant horloger (90).

14. Procédé selon l'une des revendications précédentes, dans lequel une épaisseur maximale de chaque cavité (e_{cav}) est au plus égale à 50% de l'épaisseur (e₂₀) de la couche de support (20), et de préférence au plus égale à 25% de l'épaisseur (e₂₀) de la couche de support (20).

15. Procédé selon l'une des revendications précédentes, dans lequel l'étape (b) consistant à former les composants horlogers (90) est réalisée par une technique de gravure de type DRIE.

16. Procédé selon la revendication précédente, dans lequel lors de la gravure de type DRIE réalisée à l'étape (b) une couche de fluoropolymère se forme sur les surfaces des flancs (95) des composants horlogers gravés, et la couche de protection de l'étape (c) comprend cette couche de fluoropolymère.

17. Procédé selon l'une des revendications précédentes, le procédé comprenant, après l'étape (f), une étape d'oxydation thermique suivie par une étape de désoxydation pour effectuer un lissage des composants horlogers (90) ou pour ajuster les dimensions des composants horlogers et/ou une étape de former une couche d'oxyde de silicium permanente sur au moins une partie de la surface externe des composants horlogers (90).
